(19) Europäisches Patentamt
European Patent Office
Office européen des brevets

(11) Veröffentlichungsnummer: **0 005 548**
**B1**

(12) # EUROPÄISCHE PATENTSCHRIFT

(45) Veröffentlichungstag der Patentschrift: **25.11.81**

(51) Int. Cl.³: H 01 L 31/16, H 01 C 10/00

(21) Anmeldenummer: **79101515.9**

(22) Anmeldetag: **17.05.79**

(54) **Optoelektrischer einstellbarer Widerstandsteller.**

(30) Priorität: **23.05.78 DE 2822502**

(43) Veröffentlichungstag der Anmeldung: **28.11.79 Patentblatt 79/24**

(45) Bekanntmachung des Hinweises auf die Patenterteilung: **25.11.81 Patentblatt 81/47**

(84) Benannte Vertragsstaaten: **FR GB NL**

(56) Entgegenhaltungen:
**FR-A-1 128 919**
**FR-A-1 458 148**
**GB-A-1 426 011**

(73) Patentinhaber: **Helmann GMBH, Weher Köppel 6, D-6200 Wiesbaden 1 (DE)**

(72) Erfinder: **Meyer, Jürgen, Dr. rer.nat, Rhönstrasse 28, D-6204 Taunusstein 2 (DE)**
Erfinder: **Schaaf, Norbert, Äherweg 2, D-6200 Wiesbaden (DE)**

(74) Vertreter: **Mehl, Ernst, Dipl.-Ing., Postfach 22 01 76, D-8000 München 22 (DE)**

**EP 0 005 548 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

# Optoelektrischer einstellbarer Widerstandsteiler

Die Erfindung betrifft einen optoelektrischen einstellbaren Widerstandsteiler mit den Merkmalen:

A) Als äußere Elektroden und als Abgriffelektroden dienen ortsfeste Leiterflächen an deckungsgleichen Teilen einer Fotoleiterschicht;
B) als Teilwiderstände dienen zwischen den Leiterflächen liegende Teile der Fotoleiterschicht;
C) zum Einstellen des Widerstandsteilers dient eine drehbare Belichtungsanordnung, die unterschiedliche, zwischen den Elektroden liegende Teile der Fotoleiterschicht so belichtet, daß die Summe der belichteten Teilflächen unabhängig von der Stellung der Belichtungsanordnung ist.

Klassische Potentiometer bestehen aus einem ohmschen Widerstandselement, gebildet aus einer Drahtwendel oder aus einem gestreckten Widerstandsdraht oder aus einer Widerstandsbahn. Das Element hat außen zwei elektrische Anschlüsse und dazwischen einen beweglichen Schleifkontakt als Abgriffelektrode. Der Schleifkontakt wird entweder über eine Schiebevorrichtung oder über eine Drehvorrichtung betätigt. Legt man an die äußeren Elektroden eine Spannung, dann teilt der Abgriff diese Spannung entsprechend seiner Stellung auf der Widerstandsbahn. Die Teilspannungen sind proportional den zwischen Abgriff und äußeren Elektroden liegenden Widerstandsteilen. Der gesamte ohmsche Widerstand bleibt dabei immer gleich.

Will man nicht eine Spannung teilen sondern einen elektrischen Strom, dann muß man einen in der Summe gleichbleibenden Leitwert teilen. Dazu ist das klassische Potentiometer mit der linearen proportionalen Widerstandsteilung ungeeignet. Die Summe der Teilleitwerte ist nicht konstant. Man muß eine Widerstandsbahn so teilen, daß mit der Abgriffbewegung eine lineare proportionale Leitwertteilung bewerkstelligt wird.

Unabhängig von dieser Unterscheidung einer Widerstandsteilung und einer Leitwertteilung haben die klassischen Potentiometer den Nachteil, daß am Schleifkontakt ein Rauschen und Krachen entsteht und daß die Lebensdauer durch den Kontaktverschleiß begrenzt ist.

Um dieses zu verhindern, kann man den Abgriff kontaktlos gestalten. Man ersetzt entweder den Schleifkontakt durch eine andere Kontaktierung beispielsweise durch Belichtung der gewünschten Abgriffstelle in einer Fotoleiterschiene, die dann die Verbindung der zu kontaktierenden entsprechenden Stelle im Widerstands- bzw. Leitwertelement mit der Abgriffelektrode herstellt, oder man ändert den Widerstandswert von zwei Teilelementen mit festen Abgriffsanschluß durch äußere Beeinflussung, beispielsweise durch ein Magnetfeld bei magnetfeldabhängigen Widerstandselementen.

Im ersten Fall besteht der Nachteil, daß der aktivierte und den Kontakt zur Abgriffelektrode herstellende Teil der Fotoleiterschicht selbst einen Widerstandswert hat. Im zweiten Fall ist eine Linearität schwer herzustellen, insbesondere wenn zur Teilung der gewünschten elektrischen Größe eine an die gegenständliche Teileranordnung angeschlossene elektronische Schaltung benötigt wird.

Der vorliegenden Erfindung liegt die Aufgabe zugrunde, ein Leitwert-Potentiometer zu schaffen, das keinen galvanischen Abgriffkontakt hat und das ohne großen technischen Aufwand streng linear ist.

Zur Lösung dieser Aufgabe wird ein optoelektrischer einstellbarer Widerstandsteiler der eingangs genannten Art erfindungsgemäß mit den folgenden Merkmalen ausgestattet:

a) die Fotoleiterschichtteile sind spiegelbildlich zueinander angeordnete Kreisringhälften;
b) die äußeren Elektroden kontaktieren jeweils eine der Kreisringhälften an deren äußeren Kreisbögen;
c) die Abgriffelektrode ist kreisförmig ausgebildet und kontaktiert beide Kreisringhälften an deren inneren Kreisbögen;
d) die Drehung der Belichtungsanordnung erfolgt um die Symmetrieachse der Abgriffelektrode;
e) die Summe der belichteten Teilflächen der Fotoleiterschicht ist stets gleich der Hälfte ihrer Gesamtfläche.

Zwei grundsätzliche Ausführungen sind möglich. Nach der einen verlaufen die Strombahnen durch die Leitwertschicht im wesentlichen radial. Die Fotoleiterschicht besteht dann aus zwei im wesentlichen Kreisringhälften, die in radialer Richtung zwischen einer kreisförmig begrenzten Abgriffelektrode und zwei zumindest an der Kontaktstelle im wesentlichen halbkreisförmig begrenzten äußeren Elektroden liegen.

Die zweite Ausführung weist die folgenden kennzeichnenden Merkmale auf:

a) die Fotoleiterschichtteile sind spiegelbildlich zueinander angeordnete halbkreisförmige Scheiben;
b) die äußeren Elektroden kontaktieren auf der Fotoleiterschicht jeweils eine der Scheiben;
c) die Abgriffelektrode ist kreisförmig und kontaktiert unter der Fotoleiterschicht beide Scheiben;
d) die Drehung der Belichtungsanordnung erfolgt um die Symmetrieachse der Abgriffelektrode;
e) die Summe der belichteten Teilflächen der Fotoleiterschicht ist stets gleich der Hälfte ihrer Gesamtfläche;
f) entweder die äußeren Elektroden oder die Abgriffelektrode sind lichtdurchlässig.

Nach der zweiten grundsätzlichen Ausführung

verlaufen die Strombahnen durch die Leitwertschicht im wesentlichen axial. Hier liegt die Fotoleiterschicht in axialer Richtung zwischen der Abgriffelektrode einerseits und zwei äußeren Elektroden andererseits, wobei die Kontaktflächen zur Abgriffelektrode und zu den äußeren Elektroden im wesentlichen aus Halbkreisflächen bestehen. Diese Ausführung ist niederohmiger als die erste.

Bei beiden Ausführungen ist eine strenge Linearität des Widerstandsteilers gewährleistet. Der Gesamtleitwert ist unabhängig vom Drehwinkel des Widerstandsteilers. Die Teilleitwerte sind linear mit dem Drehwinkel verknüpft.

Zwei vorteilhafte Ausgestaltungen betreffen die Belichtung. Damit die Fotoleiterschicht über die ganze Hälfte gleichmäßig belichtet wird, erfolgt die Belichtung über einen kegelförmigen, koaxial zur Fotoleiterschicht verdrehbaren Lichtleiter, in dessen Spitze sich eine Lichtquelle befindet und dessen kreisförmige Bodenfläche in einer diametralen Hälfte lichtundurchlässig ist.

Nach der anderen Ausgestaltung erfolgt die Belichtung der Fotoleiterhälfte über einen kegelförmigen, koaxial zur Fotoleiterschicht angeordneten Lichtleiter, in dessen Spitze sich eine Lichtquelle befindet, wobei eine koaxial verdrehbare Blende zwischen Lichtleiter und Fotoleiterschicht die zu belichtende Hälfte der Fotoleiterschicht bestimmt.

Nach einer weiteren vorteilhaften Ausgestaltung besteht der kegelförmige Lichtleiter aus Acrylglas mit einem Öffnungswinkel $\leq 23°$. In der Spitze des Kegels ist eine Lichtquelle eingelassen, insbesondere eine Leuchtdiode. Durch Totalreflexion an der Kegelmantelfläche wird das Licht maximal ausgenutzt.

Weitere Einzelheiten ergeben sich an Hand der folgenden Beschreibung von Ausführungsbeispielen. Von den entsprechenden Figuren der dazugehörigen Zeichnung zeigen

Fig. 1 ein erfindungsgemäßes Leitwert-Potentiometer in der Version mit einer kreisringförmigen Fotoleiterschicht,

Fig. 2 bis 4 die Abfolge von Verfahrensschritten bei der Herstellung an Hand dreier Schnitte 4-4 aus Fig. 1,

Fig. 5 ein erfindungsgemäßes Leitwert-Potentiometer in der Version mit einer kreisflächenförmigen Fotoleiterschicht,

Fig. 6 einen Schnitt 6-6 aus Fig. 5,

Fig. 7 die Anordnung eines kegelförmigen Lichtleiters zur Belichtung der Fotoleiterschicht.

In Fig. 1 bilden zwei äußere Elektroden 1 und 2 die voneinander getrennten rechteckförmigen Hälften eines Quadrats. Im Innern des Quadrats ist eine kreisförmige Fläche ausgespart. Innerhalb dieses Kreises liegt konzentrisch eine kreisflächenförmige Abgriffelektrode 3 mit kleinerem Durchmesser r. Zwischen dieser Abgriffelektrode 3 und den im wesentlichen halbkreisförmigen inneren Begrenzungen der äußeren Elektroden 1 und 2 liegen zwei im wesentlichen halbkreisringförmige Fotoleiterschichten 4 und 5 mit der Ringbreite d. Die äußeren Elektroden 1 und 2 haben äußere Anschlußpunkte 6 und 7; die Abgriffelektrode 3 ist mit einem äußeren Anschlußpunkt 8 verbunden.

Senkrecht zur diametralen Linie, die die äußeren Elektroden 1 und 2 voneinander trennt, ist eine Schnittlinie 4-4 eingezeichnet. In einem Drehwinkel $\alpha$ zu dieser Schnittlinie 4-4 ist eine diametrale Belichtungslinie eingezeichnet, die die insgesamt bis auf die Unterbrechung im wesentlichen kreisringförmige Fotoleiterschicht 4 + 5 in eine belichtete Hälfte und in eine unbelichtete Hälfte unterteilt. Die unbelichtete Hälfte der gesamten Anordnung ist schraffiert dargestellt. Die Belichtung erfolgt senkrecht zur Zeichnungsfläche. Zwischen dem äußeren Anschlußpunkt 6 und dem Abgriffanschlußpunkt 8 besteht der elektrische Leitwert G1, zwischen dem äußeren Anschlußpunkt 7 und dem Abgriffanschlußpunkt 8 der elektrische Leitwert G2. Der elektrische Leitwert G0 liegt zwischen den äußeren Anschlußpunkten 6 und 7.

In den Fig. 2 bis 4 sind drei Schnitte 4-4 aus der Fig. 1 dargestellt, anhand derer Verfahrensschritte bei der Herstellung eines Leitwert-Potentiometers nach Fig. 1 erläutert werden.

Nach Fig. 2 werden auf ein Substrat 9 aus weißer oder schwarzer Keramik oder Glas über eine Maske 10 die beiden Fotoleiterschichten 4 und 5 aus beispielsweise $CdS_xSe_{1-x}$ oder $Zn_xCd_{1-x}S$ durch Aufdampfen, Aufsprühen oder Siebdruck oder ein anderes geeignetes Verfahren aufgebracht.

Nach Fig. 3 werden die fotoleitenden Halbkreisringe 4 und 5 von einer Maske 11 abgedeckt und auf das Substrat 9 Elektrodenmaterial aus beispielsweise Indium, Aluminium oder Gold im Hochvakuum aufgedampft oder nach einem anderen geeigneten Verfahren wie beispielsweise durch Siebdruck aufgebracht. Die Masken 10 und 11 sind aus Metall und werden fotolithografisch hergestellt.

Die Fig. 4 zeigt schließlich einen Schnitt 4-4 aus der fertigen Anordnung nach Fig. 1. Das Substrat 9 trägt danach zwei äußere Elektroden 1 und 2, zwei Fotoleiter-Kreisringhälften 4, 5 und die Abgriffelektrode 3, die die beiden Fotoleiterschichten miteinander verbindet.

Durch die Belichtung der beiden Fotoleiter-Kreisringhälften 4, 5, wie in der Fig. 1 dargestellt, entstehen zwei Leitwerte G1 und G2 zwischen der Abgriffelektrode 3 einerseits und den äußeren Elektroden 1 und 2 andererseits, die vom Drehwinkel $\alpha$ abhängig sind.

Der spezifische Widerstand $\varrho$ des Fotoleiters ist durch die Belichtung $\Phi$ gegeben nach der Formel

$$\varrho = C \cdot \Phi^{-\gamma},$$

bei der C eine Konstante und $\gamma$ die Steilheit des Fotoleiters sind. C und $\gamma$ werden durch Dotierung und Gittereigenschaften des Fotoleiters bestimmt.

Nach den Fig. 5 und 6 sind die Elektroden und die Fotoleiterschichten in axialer Richtung auf

ein durchsichtiges Substrat 12 aus beispielsweise Glas aufgebracht. Das quadratische Substrat 12 trägt zunächst eine kreisflächenförmige Abgriffelektrode 13 aus durchsichtigem Material wie beispielsweise Leitglas aus $SnO_2$. Darauf sind konzentrisch zwei voneinander getrennte halbkreisflächenförmige Schichten 14 und 15 aus Fotoleitermaterial aufgebracht. Durch die Abgriffelektrode 13 werden die beiden Fotoleiterschichten 14 und 15 elektrisch miteinander verbunden, jeweils über einen im wesentlichen halbkreisflächenförmigen Kontakt. Auf den Fotoleiterschichten 14 und 15 liegen jeweils eine äußere Elektrode 16 bzw. 17 aus beispielsweise Indium. Die Kontaktflächen zwischen den Fotoleiterschichten 14 und 15 und den äußeren Elektroden 16 und 17 sind wieder im wesentlichen Halbkreisflächen, wobei die äußeren Elektroden 16 und 17 bis an den Rand des Substrats 12 durchgezogen sind und dort Anschlußpunkte 18, 19 haben. Die Abgriffelektrode 13 ist entsprechend mit einem Anschlußpunkt 20 verbunden.

Die Belichtung erfolgt wieder wie in Fig. 1 senkrecht zur Zeichnungsfläche in einer Halbkreisfläche konzentrisch zur Fotoleiterfläche, wobei die Halbkreisfläche koaxial um den Winkel $\alpha$ verdreht werden kann. Die Belichtung erfolgt in diesem Fall durch das Substrat 12, wie in der Fig. 6 dargestellt. Diese zeigt einen Schnitt 6-6 diametral senkrecht zur Trennlinie der beiden äußeren Elektroden 16 und 17 nach Fig. 5. Die Teilleitwerte G1 und G2 liegen wieder zwischen der Abgriffelektrode 13 und den äußeren Elektroden 16 und 17. Ihre Größe ist wieder durch den Drehwinkel $\alpha$ linear bestimmt, ist jedoch wesentlich größer als nach der Fig. 1, weil hier Kreisteilflächen für den wirksamen Teil des Fotoleiters maßgebend sind und nicht nur Teile von Kreisringen, multipliziert mit der Schichtdicke $\delta$.

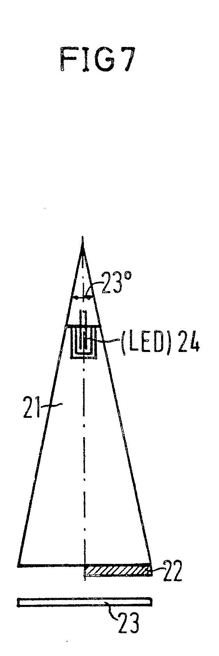

In der Fig. 7 ist schematisch die Belichtungsvorrichtung dargestellt. Ein Kegel 21 aus Acrylglas hat einen Öffnungswinkel von $\leq 23°$ und eine kreisförmige Bodenfläche, die über eine halbkreisförmige Blende 22 abgedeckt ist. Darunter befindet sich die zu belichtende Fotoleiteranordnung 23. In der Spitze des Kegels 21 ist eine Leuchtdiode 24 eingelassen, die den Boden des Kegels 21 beleuchtet. Der Kegel 21 kann um seine Achse gegen die Fotoleiteranordnung 23 verdreht werden. Das Licht der Leuchtdiode 24 wird an der Kegelmantelfläche total reflektiert, so daß es nahezu voll zur Belichtung der Fotoleiteranordnung 23 ausgenutzt werden kann, abgesehen von der Halbierung durch die Blende 22. Eine Modifikation besteht darin, den Kegel 21 feststehen zu lassen und nur die Blende 22 zu verdrehen.

## Patentansprüche

1. Optoelektrischer einstellbarer Widerstandsteiler mit den Merkmalen:

A) Als äußere Elektroden und als Abgriffselektrode dienen ortsfeste Leiterflächen an deckungsgleichen Teilen einer Fotoleiterschicht;
B) als Teilwiderstände dienen zwischen den Leiterflächen liegende Teile der Fotoleiterschicht;
C) zum Einstellen des Widerstandsteilers dient eine drehbare Belichtungsanordnung, die unterschiedliche, zwischen den Elektroden liegende Teile der Fotoleiterschicht so belichtet, daß die Summe der belichteten Teilflächen unabhängig von der Stellung der Belichtungsanordnung ist;

gekennzeichnet durch die folgenden Merkmale (Fig. 1):

a) die Fotoleiterschichtteile sind spiegelbildlich zueinander angeordnete Kreisringhälften (4, 5);
b) die äußeren Elektroden (1, 2) kontaktieren jeweils eine der Kreisringhälften (4, 5) an deren äußeren Kreisbögen;
c) die Abgriffelektrode (3) ist kreisförmig ausgebildet und kontaktiert beide Kreisringhälften an deren inneren Kreisbögen;
d) die Drehung der Belichtungsanordnung erfolgt um die Symmetrieachse der Abgriffelektrode;
e) die Summe der belichteten Teilflächen der Fotoleiterschicht ist stets gleich der Hälfte ihrer Gesamtfläche

2. Optoelektrischer einstellbarer Widerstandsteiler mit den Merkmalen:

A) Als äußere Elektroden und als Abgriffselektrode dienen ortsfeste Leiterflächen an deckungsgleichen Teilen einer Fotoleiterschicht;
B) als Teilwiderstände dienen zwischen den Leiterflächen liegende Teile der Fotoleiterschicht;
C) zum Einstellen des Widerstandsteilers dient eine drehbare Belichtungsanordnung, die unterschiedliche, zwischen den Elektroden liegende Teile der Fotoleiterschicht so belichtet, daß die Summe der belichteten Teilflächen unabhängig von der Stellung der Belichtungsanordnung ist;

gekennzeichnet durch die folgenden Merkmale (Fig. 5, 6):

a) Die Fotoleiterschichtteile sind spiegelbildlich zueinander angeordnete halbkreisförmige Scheiben (14, 15);
b) die äußeren Elektroden (16, 17) kontaktieren auf der Fotoleiterschicht jeweils eine der Scheiben (14, 15);
c) die Abgriffelektrode (13) ist kreisförmig und kontaktiert unter der Fotoleiterschicht beide Scheiben (14, 15);
d) die Drehung der Belichtungsanordnung erfolgt um die Symmetrieachse der Abgriffelektrode;
e) die Summe der belichteten Teilflächen der Fotoleiterschicht ist stets gleich der Hälfte ihrer Gesamtfläche;
f) entweder die äußeren Elektroden (16, 17)

oder die Abgriffselektrode (13) sind lichtdurchlässig.

3. Widerstandsteiler nach Anspruch 1 oder 2, dadurch gekennzeichnet, daß die Belichtungsanordnung ein kegelförmiger Lichtleiter (21) ist, in dessen Spitze sich eine Lichtquelle (24) befindet (Fig. 7).

4. Widerstandsteiler nach Anspruch 3, dadurch gekennzeichnet, daß der Lichtleiter (21) drehbar ist und an seiner kreisförmigen Bodenfläche zur Hälfte lichtundurchlässig ist.

5. Widerstandsteiler nach Anspruch 3, dadurch gekennzeichnet, daß sich zwischen Lichtleiter (21) und den Fotoleiterschichtteilen (4, 5, 14, 15) eine koaxial drehbare Blende (22) mit halbkreisförmiger Öffnung befindet.

6. Widerstandsteiler nach Anspruch 4 oder 5, dadurch gekennzeichnet, daß der Kegel (21) aus Acrylglas besteht und sein Öffnungswinkel kleiner oder gleich 23° ist.

## Claims

1. An opto-electric adjustable resistance divider having the following features:

A) outer electrodes and a tapping electrode formed by stationary conductor surfaces on non-overlapping parts of a photoconductor layer;

B) divider resistances formed by parts of the photo-conductor layer which lie between the conductor surfaces;

C) a rotable exposure arrangement for adjusting the resistance divider by exposing different parts of the photo-conductor layer which lie between the electrodes, in such manner that the sum of the exposed partial surfaces is independent of the position of the exposure arrangement;

characterised in that the following features are provided (Figure 1):

a) the parts of the photo-conductor layer are enantiomorphic circular ring halves (4, 5);

b) the outer electrodes (1, 2) each contact the outer circular arc of one of the circular ring halves (4, 5);

c) the tapping electrode (3) is circular and contacts both circular ring halves at their inner circular arcs;

d) the rotation of the exposure arrangement takes place about the axis of symmetry of the tapping electrode;

e) the sum of the exposed partial surfaces of the photo-conductor layer always equals half of its overall surface.

2. An opto-electric adjustable resistance divider having the features:

A) outer electrodes and a tapping electrode formed by stationary conductor surfaces on non-overlapping parts of a photo-conductor layer;

B) divider resistances formed by parts of the photo-conductor layer which lie between the conductor surfaces;

C) a rotatable exposure arrangement for adjusting the resistance divider by exposing different parts of the photo-conductor laver which lie between the electrodes, in such manner that the sum of the exposed partial surfaces is independent of the position of the exposure arrangement;

characterised in that the following features are provided (Figure 5, 6):

a) the parts of the photo-conductor layer are enantiomorphic semi-circular discs (14, 15);

b) the outer electrodes (16, 17) each contact one of the discs (14, 15) on the photo-conductor layer;

c) the tapping electrode (13) is circular and contacts both discs (14, 15) under the photo-conductor layer;

d) the rotation of the exposure arrangement takes place about the axis of symmetry of the tapping electrode;

e) the sum of the exposed partial surfaces of the photo-conductor layer always equals half of its overall surface;

f) either the outer electrodes (16, 17) or the tapping electrode (13) are light-transmissive.

3. A resistance divider as claimed in claim 1 or 2, characterised in that the exposure arrangement is a conical light conductor (21) in whose point there is present a light source (Figure 7).

4. A resistance divider as claimed in claim 3, characterised in that the light conductor (21) is rotable and half of its base surface light-transmissive.

5. A resistance divider as claimed in claim 3, characterised in that a coaxial rotable diaphragm (22) having a semi-circular aperture is provided between the light conductor (21) and the parts of the photo-conductor layer (4, 5, 14, 15).

6. A resistance divider as claimed in claim 4 or claim 5, characterised in that the cone (21) consists of acrylic glass and its apertural angle is smaller than or equals 23°.

## Revendications

1. Potentiomètre optoélectrique du type comportant les moyens suivants:

A) comme électrodes extérieures et électrode de prise, on utilise des surfaces conductrices fixes au niveau de parties égales d'une couche photoconductrice;

B) comme résistances partielles on utilise des parties de la couche photoconductrice qui se situent entre les surfaces conductrices;

C) pour le réglage du potentiomètre on utilise un dispositif d'éclairage susceptible de tourner et éclairant les parties différentes de la couche photoconductrice qui se situent entre les électrodes, de manière que la somme des surfaces partielles éclairées soit indépendante de la position du dispositif d'éclairage;

caractérisé par les moyens suivants (figure 1):

a) les parties de la couche photoconductrice sont des moitiés de secteurs d'un anneau de cercle (4, 5) disposées symétriquement entre elles;
b) les électrodes extérieures (1, 2) contactent respectivement une des moitiés des secteurs d'un anneau de cercle (4, 5), au niveau de leurs arcs de cercles extérieurs;
c) l'électrode de prise (3) est de forme circulaire et contacte les deux moitiés de secteurs d'un anneau de cercle, au niveau de leurs arcs de cercles extérieurs;
d) la rotation du dispositif d'éclairage est opérée autour de l'axe de symétrie de l'électrode de prise;
e) la somme des surfaces partielles éclairées de la couche photoconductrice est toujours égale à la moitié de la surface totale de cette dernière.

2. Potentiomètre optoélectrique du type comportant les moyens suivants:
A) comme électrodes extérieures et électrode de prise, on utilise des surfaces conductrices fixes au niveau de parties égales d'une couche photoconductrice;
B) comme résistances partielles on utilise des parties de la couche photoconductrice qui se situent entre les surfaces conductrices;
C) pour le réglage du potentiomètre on utilise un dispositif d'éclairage susceptible de tourner et éclairant les parties différentes de la couche photoconductrice qui se situent entre les électrodes, de manière que la somme des surfaces partielles éclairées soit indépendante de la position du dispositif d'éclairage;

caractérisé par les moyens suivantes (figures 5, 6):
a) les parties de la couche photoconductrice sont des disques (14, 15) de forme semi-circulaire disposés symétriquement entre eux;
b) les électrodes extérieures (16, 17) contactent sur la couche photoconductrice respectivement l'un des disques (14, 15);
c) l'électrode de prise (13) est de forme circulaire et contacte, sur la couche photoconductrice, les deux disques (14, 15);
d) la rotation du dispositif d'éclairage est opérée autour de l'axe de symétrie de l'électrode de prise;
e) la somme des surfaces partielles de la couche photoconductrice éclairées est toujours égale à la moitié de sa surface totale;
f) les électrodes extérieures (16, 17) ou l'électrode de prise (13) sont transparentes à la lumière.

3. Potentiomètre selon la revendication 1 ou 2, caractérisé par le fait que le dispositif d'éclairage est un conducteur de lumière (21) de forme conique au sommet duquel se situe une source lumineuse (24) (figure 7).

4. Potentiomètre selon la revendication 3, caractérisé par le fait que le conducteur de lumière (21) est susceptible de tourner et il est à moitié opaque, au niveau de sa surface de base de forme circulaire.

5. Potentiomètre selon la revendication 3, caractérisé par le fait qu'entre le conducteur de lumière (21) et les parties (4, 5, 14, 15) de la couche photoconductrice est prévu un diaphragme coaxial (22) capable de tourner et à ouverture semicirculaire.

6. Potentiomètre selon la revendication 4 ou 5, caractérisé par le fait que le cône (21) est en verre acrylique et son angle d'ouverture est inférieur ou égal à 23°.

FIG1

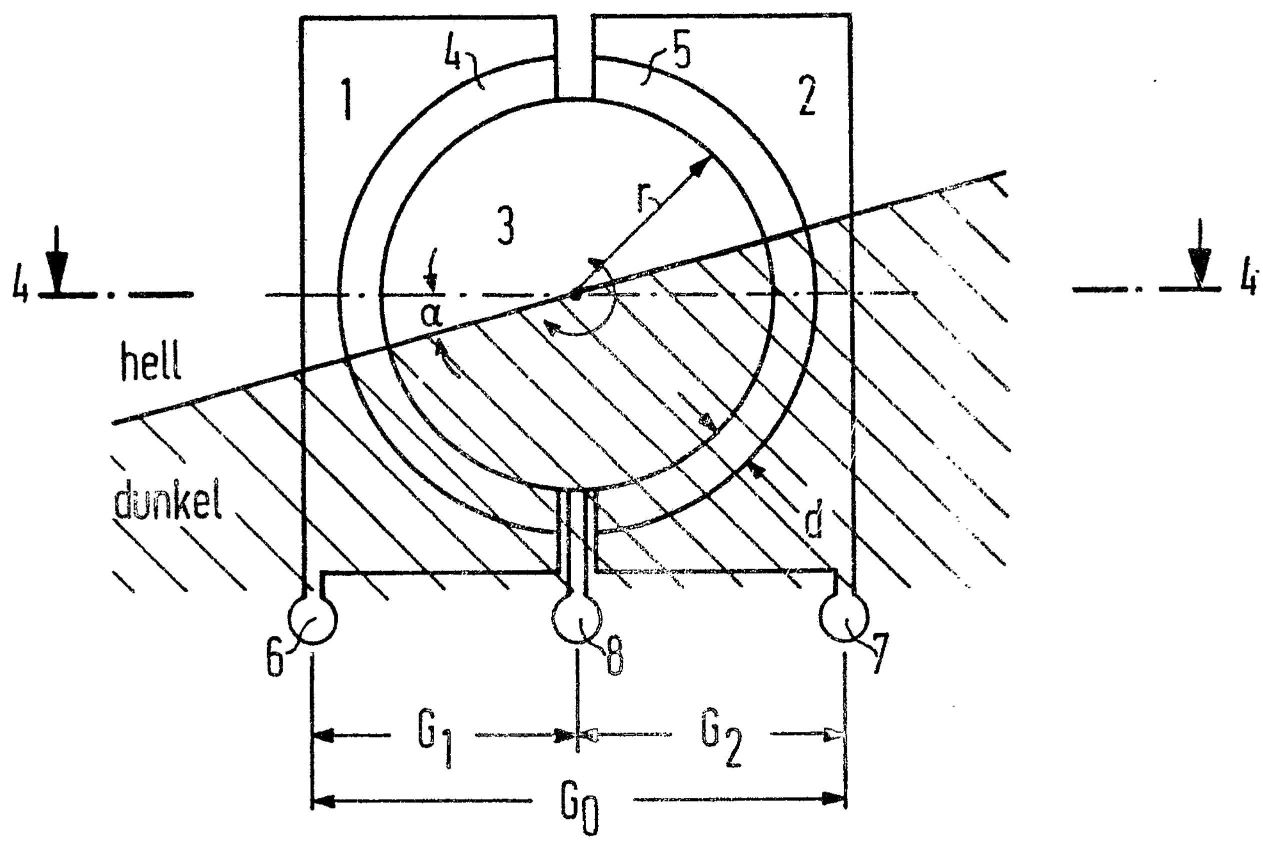

FIG 2

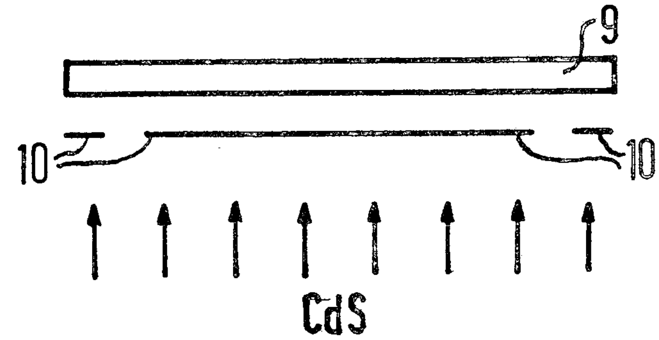


FIG 3

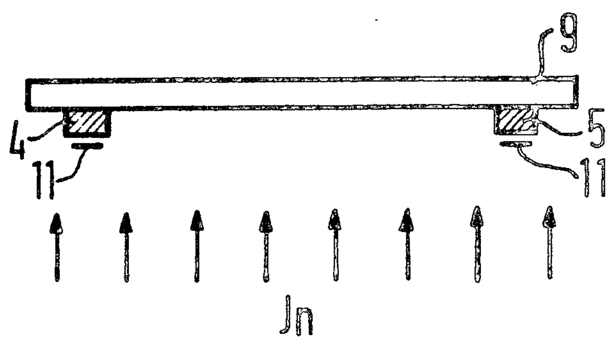


FIG 4

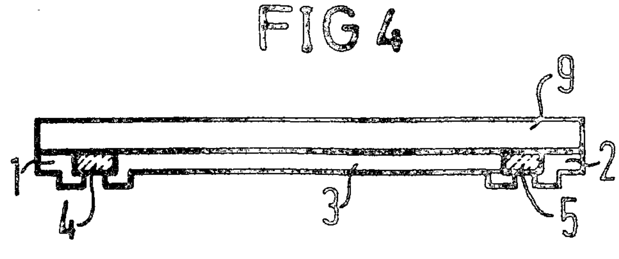

FIG 5

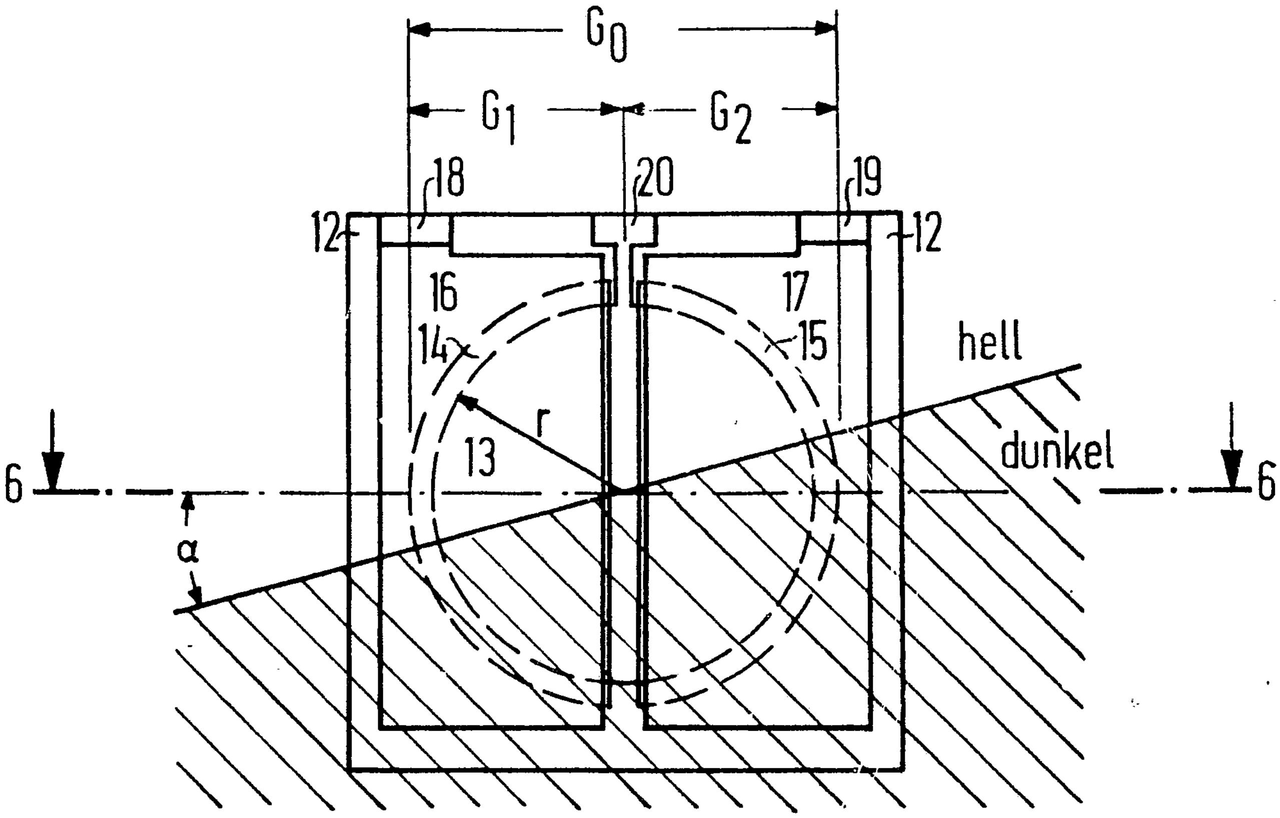
G0
G1
G2
18
20
19
12
12
16
17
14
15
hell
r
13
dunkel
6
6
α

FIG 6

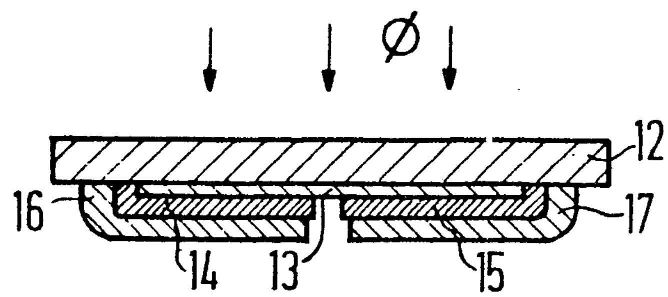
Ø
12
16
17
14
13
15

FIG 7